# DEMANDE DE BREVET EUROPEEN

(11) **EP 4 075 471 A1**
(43) Date de publication de la demande: **19.10.2022**
(21) Numéro de dépôt: 21305508.0
(22) Date de dépôt: 16.04.2021
(51) Int. Cl.: H01H 83/22, H01H 71/04, H02H 3/33, G01R 31/327

(54) **MODULE AUXILIAIRE DE PROTECTION ÉLECTRIQUE, APPAREIL DE PROTECTION ÉLECTRIQUE COMPORTANT UN TEL MODULE, ET PROCÉDÉ DE FONCTIONNEMENT ASSOCIÉ**

(71) Demandeur: Schneider Electric Industries SAS, 92500 Rueil-Malmaison (FR)
(72) Inventeur: BERNARD, Jean-Baptiste, 38180 SEYSSINS (FR); GRAND, Sébastien, 38320 BRIÉ-ET-ANGONNES (FR); PUJADAS, Eduardo, 38640 CLAIX (FR)
(74) Mandataire: Lavoix

(57) **Abrégé**

Un module auxiliaire de protection électrique (6) pour un appareil de protection électrique (2) comporte :
- un processeur (20);
- un système de mesure de position (40) configuré pour détecter la position du mécanisme de commutation ;
- un système de mesure du courant (30) configuré pour détecter un courant électrique circulant au travers de l'appareil, dans lequel le processeur est configuré pour :
- identifier, à partir au moins du système de mesure de position, un déclenchement de l'appareil de protection ;
- identifier, à partir au moins du système de mesure du courant une cause d'un déclenchement de l'appareil de protection ;
- décompter la durée écoulée depuis la dernière occurrence d'un déclenchement de l'appareil de protection causée par un défaut différentiel ;
- émettre un signal d'alarme lorsque la durée décomptée dépasse un seuil prédéfini.

## Description

La présente invention concerne un module auxiliaire de protection électrique et un appareil de protection électrique comportant un tel module. L'invention concerne également un procédé de fonctionnement d'un tel module et d'un tel appareil.

De manière connue, différents défauts peuvent se présenter dans une installation électrique, alimentée par un réseau de fourniture d'électricité, et mettre en péril la sécurité des équipements branchés dans l'installation, voire dans certains cas présenter un risque d'incendie ou un danger physique pour un opérateur.

Pour assurer la sécurité des installations électriques on utilise des appareils de protection électrique, tels que des disjoncteurs, qui sont configurés pour couper le courant électrique suite à la détection d'un défaut électrique, par exemple, suite à une détection d'un courant de surcharge, ou d'un court-circuit, ou d'un courant de fuite à la terre, ou d'un défaut d'arc électrique.

De manière classique, un disjoncteur comprend des contacts électriques fixe et mobile, le contact mobile étant adapté à se déplacer entre une position ouverte dans laquelle il est séparé du contact fixe, et donc la circulation de courant électrique est coupée, et une position fermée dans laquelle le contact mobile est en appui contre le contact fixe et la circulation de courant électrique est possible.

Le disjoncteur comprend également un mécanisme de déclenchement de coupure électrique qui entraîne le passage en position ouverte des contacts du disjoncteur, ainsi qu'une manette de réarmement, adaptée à être déplacée de la position ouverte vers la position fermée du mécanisme de déclenchement.

La manette de réarmement est en général accessible à un opérateur sur une face du boîtier contenant le disjoncteur, et est déplaçable manuellement entre une position désarmée (correspondant à la position d'ouverture des contacts) et une position armée (correspondant à la position de fermeture des contacts), et vice-versa. Le passage de la manette de la position armée à la position désarmée est entraîné automatiquement par le déclenchement d'une coupure électrique, ou manuellement par un opérateur, ou peut être piloté automatiquement par un dispositif réarmeur.

On connaît d'une part des modules de disjonction compacts, également appelés MCB pour « Miniature Circuit Breaker ». On connaît également des modules auxiliaires de protection électronique, adaptés à être connectés à des disjoncteurs magnéto-thermiques existants. De tels modules électroniques auxiliaires de protection sont configurés pour mettre en œuvre une protection par exemple, en cas d'apparition d'arcs électriques susceptibles de se produire dans des conducteurs ou connexions défectueuses. De plus, des modules auxiliaires sont configurés pour mettre en oeuvre une protection différentielle, et l'électronique de commande est adapté à réaliser une telle fonction de protection différentielle, entraînant la coupure de l'alimentation.

Les modules auxiliaires de protection peuvent être vendus séparément, ou conjointement avec des modules disjoncteurs électromécaniques, formant alors des appareils de protection électriques complets, adaptés à réaliser des fonctions de disjonction pour de multiples causes, et donc à assurer une protection optimisée d'une installation électrique. L'électronique de commande peut aussi être incluse dans le module de disjonction.

Typiquement, les appareils de protection électrique tels que les disjoncteurs différentiels sont destinés à être testés périodiquement, afin de s'assurer de leur bon fonctionnement et de vérifier leur capacité à interrompre la circulation du courant électrique en cas de défaut électrique.

Ce test peut être réalisé de différentes façons. Typiquement, les appareils de protection électrique contre les courants de fuite à la terre, tels que les disjoncteurs différentiels, comportent un bouton de test, généralement accessible en façade de l'appareil, et qui permet à un utilisateur de générer un courant différentiel de test et tester le bon fonctionnement de la protection jusqu'à l'ouverture des contacts électriques, de la même façon que si l'appareil répondait à l'apparition d'un défaut dans l'installation protégée.

Dans d'autres cas, le test peut être réalisé au moyen d'un appareillage de test qui est branché sur l'installation électrique protégée par l'appareil de protection. L'appareillage de test émet alors un signal électrique qui simule l'apparition d'un défaut électrique dans l'installation. Ce signal de test est détecté par l'appareil de protection, qui déclenche alors le mécanisme de commutation comme s'il s'agissait d'un véritable défaut.

Un problème récurrent est que de nombreux utilisateurs oublient de réaliser ce test périodiquement, dans les délais impartis, ce qui peut compromettre la fiabilité de l'appareil de protection et la sécurité de l'installation électrique, mais aussi la sécurité des utilisateurs.

Il existe donc un besoin pour un module auxiliaire de protection, et plus généralement un appareil de protection électrique, tel qu'un disjoncteur différentiel, capable d'avertir un utilisateur qu'il doit réaliser un test périodique lorsque ce test s'avère nécessaire.

Selon un aspect, l'invention propose un module auxiliaire de protection électrique pour un appareil de protection électrique comportant un mécanisme de commutation couplé à des contacts électriques, le mécanisme de commutation étant configuré pour être commuté entre une position fermée permettant le passage du courant au travers de l'appareil et une position ouverte empêchant le passage du courant, ledit module auxiliaire de protection comportant :
- un processeur ;
- un capteur de position couplé au processeur et configuré pour détecter la position du mécanisme de commutation, le capteur de position étant connecté à une source de tension pour fournir une tension de référence sur une entrée du processeur lorsque le mécanisme de commutation est dans la position fermée, le capteur de position étant configuré pour modifier ladite alimentation lorsque le mécanisme de commutation est dans la position ouverte ;
- un capteur de courant couplé au processeur et configuré pour détecter un courant électrique circulant au travers de l'appareil électrique, le module auxiliaire de protection électrique comportant un circuit de traitement connecté en sortie du capteur de courant et à une entrée du processeur;
dans lequel le processeur est configuré pour :
- identifier, à partir au moins du système de mesure de position, un déclenchement de l'appareil de protection ;
- identifier, à partir au moins du système de mesure du courant une cause d'un déclenchement de l'appareil de protection ;
- décompter la durée écoulée depuis la dernière occurrence d'un déclenchement de l'appareil de protection causée par un défaut différentiel ;
- émettre un signal d'alarme lorsque la durée décomptée dépasse un seuil prédéfini.

Selon des aspects avantageux mais non obligatoires, un tel module auxiliaire de protection électrique peut incorporer une ou plusieurs des caractéristiques suivantes, prises isolément ou suivant toute combinaison techniquement admissible :
- la durée décomptée est stockée dans une mémoire non-volatile du module auxiliaire de protection électrique ;
- le module auxiliaire comporte un dispositif de stockage d'énergie configuré pour alimenter temporairement le processeur en cas de perte d'alimentation consécutive à une commutation de l'appareil ;
- le module auxiliaire de protection comporte un annonciateur connecté à une sortie du processeur et est configuré pour émettre une alarme à destination d'un utilisateur lorsqu'il reçoit le signal d'alarme émis par le processeur ;
- l'annonciateur comporte une interface de communication radio configurée pour envoyer un message d'alerte radiofréquence ;
- l'annonciateur comporte un dispositif d'affichage graphique ou lumineux, tel qu'une lampe témoin ou un écran d'affichage ;
- le système de mesure du courant comporte un circuit de traitement connecté en sortie du capteur de courant et à une entrée du processeur, ledit circuit de traitement étant configuré pour échantillonner le courant mesuré et générer une image du courant électrique mesuré circulant au travers de l'appareil de protection ;
- le processeur est configuré pour détecter un défaut différentiel et pour transmettre un ordre de déclenchement au mécanisme de commutation ;
- le système de mesure du courant comporte un circuit de traitement connecté en sortie du capteur de courant, le circuit de traitement étant configuré pour amplifier le courant mesuré et/ou traiter de façon analogique la fonction de protection afin de détecter un défaut différentiel ;
- le circuit de traitement est configuré pour détecter un défaut différentiel et pour transmettre un ordre de déclenchement au mécanisme de commutation.

Selon un autre aspect, l'invention concerne un appareil de protection électrique comportant un module auxiliaire de protection électrique et un mécanisme de commutation couplé au module de protection, ledit module auxiliaire de protection électrique étant conforme à l'invention.

Selon un autre aspect, l'invention concerne un procédé de fonctionnement d'un module de protection électrique dans un appareil de protection électrique comportant un mécanisme de commutation couplé à des contacts électriques, le mécanisme de commutation étant configuré pour être commuté entre une position ouverte empêchant le passage du courant au travers de l'appareil et une position fermée permettant le passage du courant,
le procédé comportant des étapes mises en oeuvre par un processeur du module de protection électrique et comportant :
- identifier, à partir au moins du système de mesure de position, un déclenchement de l'appareil de protection ;
- identifier, à partir au moins du système de mesure du courant une cause d'un déclenchement de l'appareil de protection,
le système de mesure de position étant couplé au processeur et étant configuré pour détecter la position du mécanisme de commutation, le système de mesure de position étant connecté à une source de tension pour fournir une tension de référence sur une entrée du processeur lorsque le mécanisme de commutation est dans la position fermée, le système de mesure de position étant configuré pour modifier ladite alimentation lorsque le mécanisme de commutation est dans la position ouverte, le système de mesure de courant étant couplé au processeur afin de détecter un courant électrique circulant au travers de l'appareil électrique,
- décompter la durée écoulée depuis la dernière occurrence d'un déclenchement de l'appareil de protection causée par un défaut différentiel ;
- émettre un signal d'alarme lorsque la durée décomptée dépasse un seuil prédéfini.

L'invention sera mieux comprise et d'autres avantages de celle-ci apparaîtront plus clairement à la lumière de la description qui va suivre d'un mode de réalisation d'un module auxiliaire de protection électrique donnée uniquement à titre d'exemple et faite en référence aux dessins annexés, dans lesquels :
- [Fig 1] la figure 1 est une représentation schématique d'un appareil de protection électrique comportant un module auxiliaire de protection électrique conforme à des modes de réalisation de l'invention ;
- [Fig 2] la figure 2 est une représentation schématique synoptique de l'appareil de protection électrique de la figure 1 ;
- [Fig 3] la figure 3 représente des ordinogrammes illustrant le fonctionnement du module auxiliaire de protection électrique des figures 1 et 2 ;
- [Fig 4] la figure 4 est une représentation schématique de l'évolution, au cours du temps, d'un compteur du module auxiliaire de protection électrique des figures 1 et 2 pour décompter la durée depuis le dernier déclenchement de l'appareil de protection électrique.

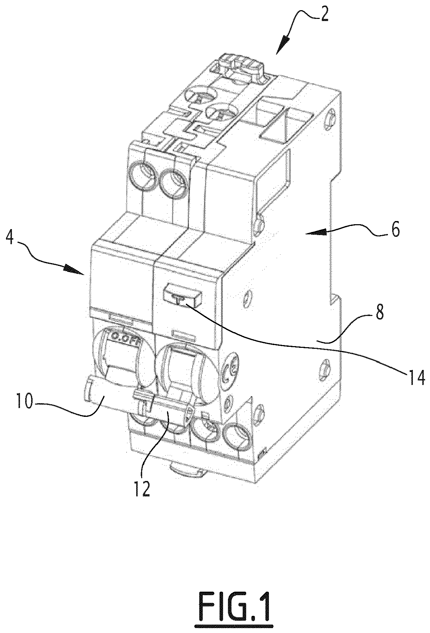

La figure 1 est une vue schématique en perspective d'un appareil de protection électrique 2, tel qu'un disjoncteur, par exemple un disjoncteur différentiel.

L'appareil 2 comporte deux modules couplés, qui sont respectivement un module de coupure 4 (aussi nommé module de disjonction magnéto-thermique) et un module électronique auxiliaire de protection électrique 6, appelé simplement module auxiliaire de protection électrique par la suite.

Le module de coupure 4 est par exemple configuré pour interrompre un courant électrique traversant l'appareil 2 en cas de défaut électrique et peut comporter à cet effet un déclencheur.

Dans certaines implémentations, les modules 4 et 6 peuvent être configurés pour détecter et réagir à différents types de défauts électriques. Par exemple, le module 4 peut détecter des court-circuits et des surintensités (défauts dits magnétiques et thermiques) tandis que le module 6 peut être configuré pour détecter des défauts différentiels ou des défauts de type arc électrique. Par exemple, le module 4 est de type électromécanique tandis que le module 6 comporte un circuit électronique de détection.

De préférence, le module 6 peut être plus particulièrement configuré pour détecter un défaut différentiel.

Avantageusement, le module auxiliaire 6 est configuré transmettre un ordre de déclenchement à destination du module de disjonction 4, de manière à déclencher l'ouverture de l'appareil 2 lorsque le module auxiliaire 6 détecte un défaut.

D'autres modes de réalisation peuvent toutefois être envisagés. Notamment, dans certains modes de réalisation, le module 6 n'est pas nécessairement à l'origine de l'ordre de commande, la détection pouvant être assurée autrement, par exemple par le module 4.

Par exemple, les rôles joués par les modules 4 et 6 pourraient être répartis différemment. Selon un exemple, le module 4 est un disjoncteur à base de composants semi-conducteurs capable de détecter les différents défauts électriques mentionnés ci-dessus.

Dans le cas présent, chaque module 4, 6 comporte un boîtier externe, le boîtier du module 6 portant ici la référence 8.

Dans l'exemple illustré, les modules sont couplés entre eux pour former l'appareil 2, via un moyen de connexion électrique et mécanique, qui n'est pas représenté sur ces figures. De préférence, les formes des boîtiers externes 6, 8 sont corrélées, en particulier les dimensions sont choisies de manière à réaliser un emboîtement mécanique aisé.

Dans cet exemple, le module 6 peut être un module amovible séparable du module 4.

Dans certains cas, les modules 4 et 6 peuvent être intégrés au sein d'un même appareil 2. Par exemple, selon une variante, les modules 4 et 6 sont intégrés dans un boîtier monobloc qui forme le boîtier de l'appareil 2.

Chaque boîtier comporte une face avant destinée à être facilement accessible à un opérateur après installation du dispositif de disjonction.

En pratique, sur les faces avant respectives chaque module 4, 6 peuvent se trouver des connecteurs destinés à recevoir des conducteurs électriques pour relier l'appareil 2 à l'installation électrique destinée à être protégée.

De plus, une première manette de réarmement 10 est placée sur la face avant du boîtier du module 4 et une deuxième manette de réarmement 12 est ici placée sur la face avant du boîtier 8 du module auxiliaire de protection 6.

De préférence, dans les variantes où les modules 4 et 6 ont intégrés dans un même appareil, alors l'appareil ne comprend qu'une manette de réarmement 10.

Dans le mode de réalisation illustré, chaque manette 10, 12 est adaptée à pivoter autour d'un axe, entre une première position et une deuxième position décrites plus en détail ci-après. La deuxième manette 12 est ici mécaniquement liée ou polarisée à la première manette 10.

Dans le mode de réalisation de la figure 1, l'appareil 2 est dans un premier état qui est l'état dit « fermé », c'est-à-dire que le courant électrique peut circuler dans l'installation électrique protégée (non représentée).

Dans ce premier état, les manettes 10, 12 sont dans une première position (position armée, également appelée position fermée). Alternativement, l'appareil 2 peut être placé de façon réversible dans un deuxième état dit « ouvert », dans lequel la circulation du courant électrique est coupée. Dans ce deuxième état, les manettes 10 et 12 sont dans une deuxième position (position désarmée, également appelée position ouverte).

Le passage du premier état au deuxième état est par exemple déclenché par le déclenchement du mécanisme de protection du module 4, ce qui entraîne l'ouverture des contacts du module de disjonction et une modification de la position de la manette 10. En variante, le passage du premier état vers le deuxième état est déclenché par une manipulation manuelle d'un opérateur.

Grâce à l'asservissement mécanique décrit ci-dessus, le pivotement de la manette 10 entre la première position et la deuxième position entraîne le pivotement analogue de la manette 12.

Dans d'autres modes de réalisation, la manette 12 pourrait être omise, et le couplage entre les modules 4 et 6 pourrait être réalisé d'une ou de plusieurs autres façons.

Comme on le comprendra à la lecture de la description qui va suivre, dans le cas présent, le couplage entre les manettes 10 et 12 permet avantageusement de détecter la position du mécanisme de commutation du module 4 au moyen d'un ou de plusieurs capteurs disposés dans le module auxiliaire 6. Toutefois, en variante, un ou plusieurs capteurs de position pourraient être placés directement dans le module 4.

L'appareil 2 comporte également un bouton de test 14 placé de préférence sur une des faces avant, par exemple sur la face avant du module 6 (comme illustré sur la figure 1) ou sur la face avant du module 4 (variante non illustrée).

Le bouton de test 14 est configuré pour générer un défaut électrique capable de déclencher l'appareil et ainsi d'initier le déplacement du mécanisme de commutation de l'état fermé vers l'état ouvert lorsqu'un utilisateur appuie sur le bouton de test 14. Ainsi, ce bouton de test 14 permet de tester l'appareil 2 dans son ensemble (en testant tous les constituants de la protection du capteur jusqu'au mécanisme d'ouverture des contacts). Par exemple, le bouton de test 14 est configuré pour déclencher un circuit de test configuré pour générer en interne ledit courant de défaut.

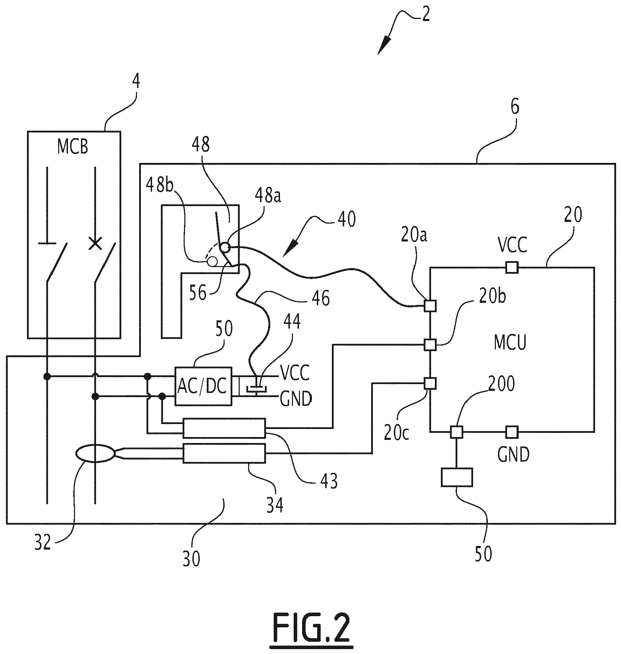

La figure 2 illustre de façon schématique un mode de réalisation de l'appareil 2.

De façon générale, le module auxiliaire de protection 6 comporte un processeur 20, un système 30 de mesure du courant et un système 40 de mesure de position du mécanisme de commutation.

Par exemple, le système 40 de mesure de la position, qui peut comporter un capteur de position ou des moyens de mesure de la position du mécanisme de commutation, 40 est couplé au processeur et est configuré pour détecter la position du mécanisme de commutation.

Le système de mesure du courant 30 est couplé au processeur en vue de détecter un courant électrique circulant au travers de l'appareil 2.

Par exemple, le processeur 20 (noté MCU sur la figure 2) est un microcontrôleur programmable ou un microprocesseur.

Le processeur 20 est couplé à une mémoire informatique, ou à tout support d'enregistrement de données lisible par ordinateur, qui comporte des instructions exécutables et/ou un code logiciel prévu pour mettre en œuvre un procédé de surveillance de la fonction de test, par exemple comme décrite ci-après, lorsque ces instructions sont exécutées par le processeur.

L'emploi du terme « processeur » ne fait pas obstacle à ce que, en variante, au moins une partie des fonctions du module 6 soient réalisées par d'autres composants électroniques, tels qu'un processeur de traitement du signal (DSP), ou un composant logique reprogrammable (FPGA), ou un circuit intégré spécialisé (ASIC), ou tout élément équivalent, ou toute combinaison de ces éléments.

Avantageusement, le module 6 comporte une mémoire non volatile couplée au processeur 20. Le processeur 20 est configuré pour implémenter un compteur, notamment pour décompter une durée écoulée. Le processeur 20 peut aussi enregistrer une valeur représentative de cette durée dans la mémoire non-volatile. Par exemple, la mémoire non-volatile peut comporter une mémoire à l'état solide, telle qu'une mémoire Flash, ou une mémoire EEPROM, ou toute technologie équivalente.

De façon générale, comme on le comprendra à la lecture de la description qui va suivre, le processeur 20 est configuré pour :
- identifier, à partir au moins du système de mesure de position 40, un déclenchement de l'appareil de protection ;
- identifier, à partir au moins du système de mesure du courant 30, une cause d'un déclenchement de l'appareil de protection ;- décompter la durée écoulée depuis la dernière occurrence d'un déclenchement de l'appareil 2 causée par un défaut différentiel, c'est-à-dire par un courant de fuite à la terre, et
- émettre un signal d'alarme lorsque la durée décomptée dépasse un seuil prédéfini, ce seuil pouvant par exemple être fixé à l'avance ou modifié par un utilisateur.

Notamment, utiliser des données provenant à la fois du capteur de position 40 et du système de mesure du courant 30 permet de déterminer la cause du déclenchement de l'appareil 2 et notamment de s'assurer que le mécanisme de commutation (de même que les contacts électriques du module 4) a été ouvert suite à un déclenchement, et non pas suite à une action manuelle d'un utilisateur sur la manette 10 (cette dernière action ne faisant pas intervenir le circuit de détection). Avantageusement, cela permet de déterminer si le déclenchement a été causé par la présence d'un défaut différentiel, ou par un autre type de défaut.

En pratique, l'étape d'identification du déclenchement de l'appareil 2, et l'étape d'identification du type du défaut peuvent être mises en œuvre simultanément, ou l'une après l'autre.

Dans des modes de réalisation, le module auxiliaire de protection comporte un annonciateur 50 connecté à une sortie 20d du processeur et qui est configuré pour émettre une alarme à destination d'un utilisateur lorsqu'il reçoit le signal d'alarme émis par le processeur 20.

Par exemple, l'annonciateur 50 comporte une interface de communication radio configurée pour envoyer un message d'alerte radiofréquence.

L'interface de communication radio peut être une liaison radio de type Bluetooth (marque déposée) ou une liaison bas débit de longue portée, par exemple de type Zigbee (marque déposée).

Dans d'autres exemples, l'annonciateur 50 comporte un dispositif d'affichage graphique ou lumineux, tel qu'une lampe témoin ou un écran d'affichage.

Par exemple, l'annonciateur 50 comporte un indicateur visuel tel qu'une lampe témoin, par exemple une diode électroluminescente.

En pratique, il peut s'agir d'une lampe témoin déjà présente en façade de l'appareil 2 et utilisée comme indicateur visuel pour d'autres fonctions de l'appareil 2.

Dans certains modes de réalisation, l'annonciateur 50 peut être configuré pour envoyer une information (telle que le message d'alerte) à distance selon un protocole de communication visuelle VLC (Visual Light Communication).

Par exemple, l'annonciateur 50 comporte un contrôleur électronique connecté à l'indicateur lumineux et étant configuré pour faire clignoter l'indicateur lumineux d'une certaine façon (avec une fréquence spécifique ou un motif de clignotement spécifique) pour transmettre une information encodée.

Selon un mode de réalisation, les systèmes de mesure 30 et 40, de même que le couplage des modules 4 et 6, peuvent être réalisés tels que décrits dans la demande de brevet FR-3100654-A1.

En variante, d'autres modes de réalisation sont possibles, avec différents types de capteurs et/ou de couplages utilisés.

Dans l'exemple illustré sur la figure 2, le système de mesure du courant 30 comporte un capteur de courant 32, tel qu'un capteur toroïdal comprenant un tore magnétique, ou un transformateur de courant, monté autour d'un conducteur électrique de phase (ou, dans le cas d'une protection différentielle, autour du conducteur de phase et du conducteur de neutre), ce capteur 32 étant configuré pour mesurer le courant circulant au travers de l'appareil 2 et donc dans le module 4.

Le capteur de courant 32 est connecté à un circuit de traitement 34 configuré pour mettre en forme de courant. Une sortie du circuit de traitement 34 est ici connectée à une entrée 20c du processeur 20.

Selon un premier mode de réalisation, le circuit de traitement 34 est configuré pour générer une image du courant mesuré compatible avec les spécifications du processeur 20. Par exemple, le circuit de traitement est configuré pour échantillonner le courant mesuré et générer une image du courant électrique mesuré circulant au travers de l'appareil de protection.

Dans ce cas, le processeur 20 est de préférence configuré pour identifier un défaut différentiel à partir de l'image du courant fournie par le circuit de traitement 34, l'ordre de déclenchement étant alors émis par le processeur 20. En d'autres termes, le processeur 20 est configuré pour détecter un défaut différentiel et pour transmettre un ordre de déclenchement au mécanisme de commutation (donc ici au module 4)

En variante, selon un deuxième mode de réalisation, le circuit de traitement 34 peut amplifier le courant mesuré et/ou traiter de façon analogique la fonction de protection. Notamment, le circuit de traitement 34 peut être configuré pour détecter un défaut différentiel sans avoir besoin du processeur 20.

Dans ce cas, c'est de préférence le circuit de traitement 34 qui identifie le défaut différentiel et qui émet l'ordre de déclenchement pour déclencher l'ouverture de l'appareil 2. En d'autres termes, le circuit de traitement 34 est configuré pour détecter un défaut différentiel et pour transmettre un ordre de déclenchement au mécanisme de commutation (donc ici au module 4).

D'autres modalités de construction sont néanmoins possibles en variante.

Dans cet exemple, le capteur de position 40 fait partie d'un système configuré pour déterminer la de cause de défaut électrique à l'origine de la commutation.

Dans cet exemple, le capteur de position 40 est connecté entre le conducteur de neutre et le conducteur de phase de l'appareil 2.

Un module 43 de mise en forme de la tension, reçoit en entrée une mesure de tension fournie par le réseau d'alimentation, et effectue une mise en forme de la tension compatible avec les spécifications du processeur 20.

Par exemple, dans un mode de réalisation, le module 43 met en œuvre un pont diviseur de tension. La sortie du module 43 de mise en forme de la tension fournit une image de la tension du réseau à une deuxième entrée 20b du processeur 2.

Un convertisseur de tension 50, configuré pour convertir une tension alternative en tension continue (AC/DC) pour fournir une tension d'alimentation de référence continue (Vcc), permet de créer une tension de référence continue (DC) qui peut être utilisée pour déterminer la position du mécanisme au travers d'interrupteurs mécaniques. Elle peut aussi être utilisée pour alimenter électriquement le processeur 20.

Le système comprend aussi un dispositif de stockage d'énergie 44, tel qu'un condensateur, connecté au mécanisme de déclenchement de la manette.

Une des bornes du dispositif de stockage d'énergie 44 est connectée à la masse (notation GND sur la figure).

La position du mécanisme de commutation est ici déterminée indirectement à partir de la manette 12 du module auxiliaire de protection 6, bien qu'en variante d'autres manières de détecter la position du mécanisme de commutation pourraient être utilisées.

La manette 12 est ici représentée schématiquement par un interrupteur 48, qui peut être fermé (position 48a), ou ouvert (position 48b). Le dispositif de stockage d'énergie 44 est connecté à l'interrupteur 48 via le conducteur 46. L'interrupteur 48 est également connecté à une troisième entrée 20a du processeur 20.

En pratique, dans ces modes de réalisation, la tension lue sur l'entrée 20a du processeur 20 est égale à 0V si l'interrupteur 48 est ouvert ou s'il y a une perte d'alimentation électrique induisant une perte de tension de référence.

En d'autres termes, le système de mesure de position 40 est connecté à une source de tension pour fournir une tension de référence sur une entrée du processeur lorsque le mécanisme de commutation est dans la position fermée, le capteur de tension étant configuré pour modifier ladite alimentation lorsque le mécanisme de commutation est dans la position ouverte.

Avantageusement, le dispositif de stockage d'énergie 44 permet de distinguer entre ces deux cas de figure, ou en d'autres termes, de déterminer si la perte de tension détectée sur l'entrée 20a du processeur 20 est due à une ouverture de l'interrupteur 48 (c'est-à-dire un changement de position de la manette) ou à une perte d'alimentation en tension.

En pratique, le dispositif de stockage d'énergie 44 permet d'alimenter temporairement le processeur 20 en cas de perte d'alimentation en tension après le déclenchement. En effet, l'ouverture des contacts peut avoir pour effet d'interrompre l'alimentation électrique du module 6.

Par exemple, il est possible que le module auxiliaire de protection ne soit plus alimenté si une coupure est intervenue en amont du réseau d'alimentation, sans que l'appareil 2 n'ait pu être déclenché.

Le dispositif de stockage d'énergie 44 permet de faire fonctionner le processeur 20 pendant suffisamment longtemps (par exemple pendant quelques dizaines ou quelques centaines de millisecondes après la perte d'alimentation) pour stocker dans la mémoire non-volatile les informations à utiliser au prochain redémarrage.

Le processeur 20 peut être configuré pour mémoriser les valeurs de tension et de courant reçues sur les entrées 20a, 20b et 20c sur des fenêtres temporelles glissantes de durées prédéterminées, par exemple de durée comprise entre 0 et 80 ms, soit 8 demi-cycles à la fréquence réseau de 50 Hz.

Le processeur 20 peut être configuré pour mettre en œuvre un procédé de détermination de cause de déclenchement du mécanisme de disjonction, tel que celui décrit dans la demande de brevet FR-3100654-A1.

Par exemple, lorsque le module auxiliaire 6 est alimenté via le module 4 (par exemple parce que la source d'alimentation de l'installation est située en amont de l'appareil 2), une perte de tension simultanée ou quasi simultanée sur les entrées 20a et 20b du processeur 20 indique que la manette 10 du module 4 est passée en position « désarmée », par action manuelle ou par action du déclencheur.

D'autres modes de réalisation sont néanmoins possibles.

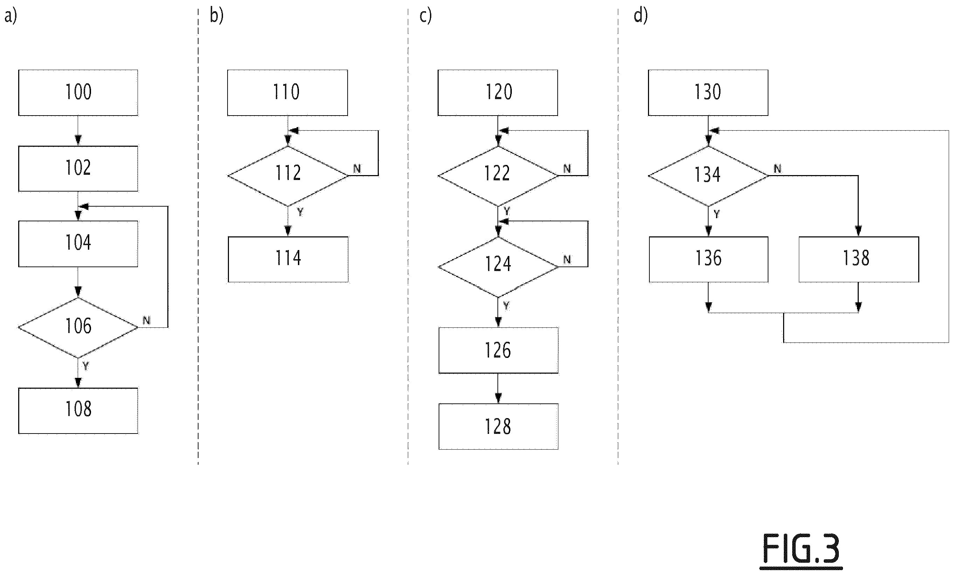

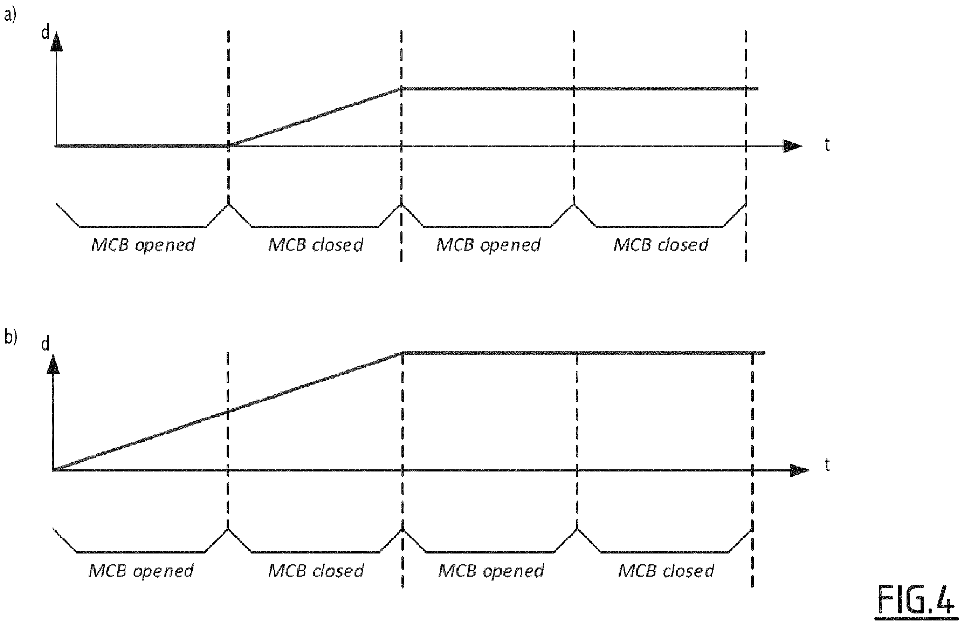

Un exemple de fonctionnement du module 6 est maintenant décrite en référence aux figures 3 et 4.

L'insert (a) de la figure 3 décrit un exemple d'un procédé de gestion du compteur mis en œuvre par le processeur 20 pour décompter la durée de fonctionnement de l'appareil 2 depuis le dernier déclenchement.

Le procédé débute à l'étape 100.

D'abord, lors d'une étape 102, le processeur 102 lit la dernière valeur du compteur stockée en mémoire.

Ensuite, lors d'une étape 104, la valeur lue est incrémentée, par exemple avec un intervalle de durée prédéfini. La valeur peut être stockée dans une mémoire courante du processeur 20.

Lors d'une étape 106, le processeur vérifie si une perte de tension électrique a été détectée. Si tel est le cas, la valeur courante de la durée est stockée dans la mémoire non-volatile, ici lors d'une étape 108, afin d'éviter toute perte d'information au cas où le processeur 2 viendrait à ne plus être alimenté électriquement du fait de la perte de tension.

Avantageusement, pendant cette étape 108, le processeur 20 est temporairement alimenté électriquement par le dispositif de stockage d'énergie 44. Ainsi, les informations pertinentes ont le temps d'être enregistrées dans la mémoire non-volatile avant que le processeur 20 ne s'arrête à cause de la perte d'alimentation.

Tant qu'aucune perte de tension n'est détectée, le processeur 20 continue à incrémenter valeur courante de la durée sans forcément la sauvegarder dans la mémoire non volatile.

L'insert (b) de la figure 3 décrit un exemple d'un procédé de gestion d'une alarme mis en œuvre par le processeur 20 si la durée de fonctionnement de l'appareil 2 décomptée depuis le dernier déclenchement dépasse un seuil prédéfini de durée.

Par exemple, le seuil prédéfini est choisi égal à une année.

Le seuil prédéfini peut être fixé par le constructeur en usine sans forcément pouvoir être modifié par la suite. Alternativement, la valeur peut être modifiée par un utilisateur ou par un installateur.

Le procédé débute à l'étape 110.

Lors d'une étape 112, le processeur 20 vérifie si la valeur du compteur est supérieure ou égale au seuil prédéfini.

Si tel est le cas, alors lors d'une étape 114, le processeur 20 génère un signal d'alarme.

Par exemple, le signal d'alarme est ensuite envoyé sur la sortie 20d du processeur vers l'annonciateur 50, qui génère une alarme visuelle ou sonore et/ou un message radiofréquence à destination d'un utilisateur.

En revanche si la valeur de durée du compteur est inférieure au seuil prédéfini, alors l'étape 112 est répétée.

L'insert (c) de la figure 3 décrit un exemple d'un procédé de gestion du compteur mis en œuvre par le processeur 20 pour réinitialiser l'alarme suite à un déclenchement de l'appareil 2 causé par un défaut différentiel.

Le procédé débute à l'étape 120.

Lors d'une étape 122, le processeur 20 vérifie si un défaut électrique de type défaut électrique, tel qu'un défaut différentiel a causé le déclenchement de l'appareil 2.

Dans le cas où un tel défaut a été détecté, lors d'une étape 124, le processeur 20 vérifie ensuite si le mécanisme de commutation s'est correctement déplacé en réponse au déclenchement.

Dans le cas où un tel déplacement a été détecté à l'issue de l'étape 126, alors lors de l'étape 126, le processeur 20 cesse d'émettre un signal d'alarme (par exemple en réinitialisant un drapeau d'alarme), mais seulement dans le cas où la valeur du compteur est supérieure ou égale au seuil prédéfini.

Lors d'une étape 128, le processeur réinitialise le compteur.

Dans le cas où, suite aux étapes 122 et 124, le processeur n'a pas détecté de déclenchement ou de mouvement du mécanisme de commutation, respectivement, alors l'étape concernée continue à être répétée.

Plus précisément, les étapes 122 et 124 sont répétées en boucle tant que l'appareil 2 est en fonctionnement et tant qu'aucun défaut n'a été détecté. Avantageusement, cela permet de signaler un dysfonctionnement tel que dans le cas où un ordre de déclenchement a été détecté mais que le disjoncteur 4 n'a pas ouvert les contacts.

En pratique, les étapes 122 et 124 peuvent être réalisées en parallèle l'une de l'autre, voire dans un ordre différent. Par exemple, l'étape 124 pourrait être réalisée avant l'étape 122, pour d'abord détecter une ouverture de l'appareil, puis ensuite identifier la cause du défaut.

L'insert (d) de la figure 3 décrit un exemple d'un procédé de fonctionnement de l'annonciateur 50.

Le procédé débute à l'étape 130.

Lors d'une étape 134, l'annonciateur 50 vérifie si un signal d'alarme émis par le processeur 20 est présent.

Dans le cas où un tel signal d'alarme est présent, alors au cours d'une étape 136, l'annonciateur 50 émet un message d'alarme à destination de l'utilisateur, par exemple en activant le clignotement d'un indicateur visuel suivant une fréquence prédéfinie.

Selon la nature de l'annonciateur 50, le message d'alarme peut être émis de façon différente, par exemple en affichant un message ou un pictogramme sur un écran d'affichage, ou selon un protocole de communication visuelle VLC (tel que décrit précédemment) ou en émettant un signal sonore, ou en envoyant un ou plusieurs messages radiofréquences contenant un message d'alarme prédéfini.

Alternativement, différents types de messages peuvent être combinés, par exemple si différents annonciateurs 50 sont connectés en sortie du processeur 20.

Ainsi, l'utilisateur peut choisir d'avoir une alarme émise localement, ou une alarme distante, ou les deux.

L'émission du message d'erreur peut être maintenue continument ou être réalisée seulement pendant une durée prédéfinie.

Dans le cas où, à l'issue de l'étape 134, un tel signal d'alarme n'est plus présent, alors au cours d'une étape 138, l'annonciateur 50 cesse d'émettre le message

En variante, les étapes pourraient être exécutées dans un ordre différent. Certaines étapes pourraient être omises. L'exemple décrit ne fait pas obstacle à ce que, dans d'autres modes de réalisation, d'autres étapes soient mises en œuvre conjointement et/ou séquentiellement avec les étapes décrites.

Grâce à l'invention, il est possible de compter le temps écoulé depuis le dernier déclenchement causé par un défaut différentiel (c'est-à-dire par un courant de fuite à la terre), que ce défaut ait été généré lors d'un test ou qu'il ait résulté d'un véritable défaut dans l'installation électrique, et ainsi, facilement alerter un utilisateur qu'un test doit être réalisé s'il est établi qu'aucun test n'a été réalisé dans le délai imparti.

Un avantage de l'invention est qu'elle permet de détecter si un test a été réalisé quelle que soit la méthode de test utilisée, que ce test ait été réalisé avec le bouton de test 14 (et avec le dispositif d'autotest commandé par ce bouton de test 14) ou avec l'aide d'un appareillage de test connecté à l'installation et injectant un signal électrique de test pour simuler un défaut électrique.

Un autre avantage est que l'invention permet de discriminer entre un déclenchement du module 4 provoqué par un défaut différentiel (qui justifie la réinitialisation du compteur), d'une part, et d'une ouverture manuelle du module 4 par action sur la manette 10 qui ne devrait pas réinitialiser le compteur, d'autre part (puisque dans ce cas l'ouverture des contacts n'est pas due à l'action du dispositif de détection et de déclenchement et qu'elle ne permet pas de s'assurer que l'appareil a 2 correctement détecté le défaut différentiel ni qu'il a correctement réagi au défaut différentiel). Le compteur n'est donc pas réinitialisé lorsque la commutation à l'ouverture de l'appareil 2 est causée par autre chose qu'un défaut différentiel.

Un autre avantage, comme expliqué précédemment, est que l'invention rend l'appareil 2 capable d'avertir l'utilisateur d'un déclenchement anormal du module 4, par exemple dans le cas où un défaut a été identifié mais que le module 4 n'a pas été déclenché, par exemple parce que la manette est bloquée en position armée (ou ouverte) et que le courant électrique a malgré tout été interrompu par un autre appareil de protection connecté près de la source d'alimentation.

L'invention fonctionne également que l'appareil 2 soit alimenté par une source électrique située en amont ou en aval. En effet, en pratique, le processeur 20 est ici au moins en partie alimenté électriquement au moyen d'énergie électrique prélevée à partir du conducteur de phase.

Si par exemple la source d'alimentation de l'installation est située en amont de l'appareil 2, c'est-à-dire au-dessus de l'appareil sur le schéma de la figure 2, alors l'appareil 2 (et donc le processeur) cessera d'être alimenté électriquement lorsque les contacts du module 4 sont ouverts.

En effet, typiquement, le module 6 ne comporte pas de batterie ou de pile électrique, car ces derniers sont trop volumineux et trop complexes à intégrer, d'autant plus que pour des raisons de construction de l'appareil 2, il serait très difficile à un utilisateur de remplacer une telle pile ou batterie. De surcroît, une telle batterie ou pile ne présenterait pas une durée de vie suffisante par rapport à la durée de vie d'un appareil 2, qui est généralement prévu pour durer plusieurs années voire plusieurs décennies.

L'invention est également applicable aux appareils 2 qui comportent tout de même une batterie intégrée. L'invention permet au moins de rendre plus précise l'estimation du temps écoulé depuis le dernier test ou déclenchement causé par un défaut différentiel.

Dans ce cas, la durée de fonctionnement enregistrée correspond non pas à une durée calendaire décomptée depuis le dernier déclenchement causé par un défaut différentiel, mais plutôt à une durée de fonctionnement du module 6 (et donc de l'appareil 2) depuis un tel différentiel (car le compteur cesse d'être incrémenté lorsque le module 6 n'est pas alimenté, par exemple si l'ouverture de l'appareil 2 a pour effet d'interrompre l'alimentation électrique du module 6).

En revanche, dans le cas où l'appareil 2 est alimenté par une source située en aval c'est-à-dire au-dessous de l'appareil sur le schéma de la figure 2, alors l'appareil 2 (et donc le processeur) sera toujours alimenté électriquement même lorsque les contacts du module 4 sont ouverts.

De plus, l'invention peut être aisément implémentée dans des produits existants, en utilisant des capteurs déjà présents, sans avoir à modifier leur architecture.

L'insert (a) de la figure 4 illustre l'incrémentation de la valeur de durée stockée dans le compteur (d, axe des ordonnées) au cours du temps (t, axe des abscisses) lors de plusieurs cycles d'ouverture (légende : MCB opened) et de fermeture (légende : MCB closed) du mécanisme de commutation, pour un appareil 2 alimenté par une source située en amont (au-dessus) de l'appareil 2.

Comme illustré par la figure, lors du premier cycle d'ouverture-fermeture, l'appareil 2 est alimenté électriquement par le réseau. Le compteur est incrémenté après la phase d'ouverture, pendant la phase de fermeture. Lors du second cycle (et des cycles suivants), l'appareil 2 n'est plus alimenté, et le compteur n'est pas incrémenté. En effet, lorsque l'appareil 2 (le module 3) n'est pas alimenté par le réseau, seule une ouverture manuelle par action sur la manette 10 peut alors causer une ouverture des contacts électriques.

Mais, avantageusement, la valeur du compteur a entre-temps été enregistrée dans la mémoire non volatile.

L'insert (b) de la figure 4 illustre l'incrémentation de la valeur de durée stockée dans le compteur (d, axe des ordonnées) au cours du temps (t, axe des abscisses) lors de plusieurs cycles d'ouverture (légende : MCB opened) et de fermeture (légende : MCB closed) du mécanisme de commutation, pour un appareil 2 alimenté par une source située en aval (en-dessous) de l'appareil 2.

Comme illustré par la figure, lors du premier cycle d'ouverture-fermeture, l'appareil 2 est alimenté électriquement par le réseau. Le compteur est incrémenté graduellement pendant la phase d'ouverture et pendant la phase de fermeture. Lors du second cycle (et des cycles suivants), l'appareil 2 n'est plus alimenté, et le compteur n'est pas incrémenté.

Mais, avantageusement, là encore, la valeur du compteur a entre-temps été enregistrée dans la mémoire non volatile.

Par exemple, l'information sur la position de la source d'alimentation électrique (amont ou aval) peut être renseignée dans une mémoire de l'appareil 2 lors de l'installation, la façon d'incrémenter le compteur étant ensuite choisie par le processeur en fonction de cette information.

Les modes de réalisation et les variantes envisagés ci-dessus peuvent être combinés entre eux pour créer de nouveaux modes de réalisation.

## Revendications

1. Module auxiliaire de protection électrique (6) pour un appareil de protection électrique (2) comportant un mécanisme de commutation couplé à des contacts électriques (4), le mécanisme de commutation étant configuré pour être commuté entre une position fermée permettant le passage du courant au travers de l'appareil et une position ouverte empêchant le passage du courant, ledit module auxiliaire de protection comportant :
- un processeur (20) ;
- un système de mesure de position (40) couplé au processeur et configuré pour détecter la position du mécanisme de commutation, le système de mesure de position (40) étant connecté à une source de tension pour fournir une tension de référence sur une entrée du processeur lorsque le mécanisme de commutation est dans la position fermée, le système de mesure de position étant configuré pour modifier ladite alimentation lorsque le mécanisme de commutation est dans la position ouverte ;
- un système de mesure du courant (30) couplé au processeur et configuré pour détecter un courant électrique circulant au travers de l'appareil électrique ;
dans lequel le processeur est configuré pour :
- identifier, à partir au moins du système de mesure de position (40), un déclenchement de l'appareil de protection ;
- identifier, à partir au moins du système de mesure du courant (30) une cause d'un déclenchement de l'appareil de protection ;
- décompter (102, 104, 108) la durée écoulée depuis la dernière occurrence d'un déclenchement de l'appareil de protection causée par un défaut différentiel ;
- émettre un signal d'alarme (132) lorsque la durée décomptée dépasse un seuil prédéfini.

2. Module auxiliaire de protection électrique selon la revendication 1, dans lequel la durée décomptée (d) est stockée dans une mémoire non-volatile du module auxiliaire de protection électrique.

3. Module auxiliaire de protection électrique selon la revendication 2, dans lequel le module auxiliaire (6) comporte un dispositif de stockage d'énergie (42) configuré pour alimenter temporairement le processeur en cas de perte d'alimentation consécutive à une commutation de l'appareil (2).

4. Module auxiliaire de protection électrique selon l'une quelconque des revendications précédentes, dans lequel le module auxiliaire de protection comporte un annonciateur (50) connecté à une sortie (22d) du processeur et est configuré pour émettre une alarme à destination d'un utilisateur lorsqu'il reçoit le signal d'alarme émis par le processeur.

5. Module auxiliaire de protection électrique selon la revendication 3, dans lequel l'annonciateur (50) comporte une interface de communication radio configurée pour envoyer un message d'alerte radiofréquence.

6. Module auxiliaire de protection électrique selon la revendication 3, dans lequel l'annonciateur (50) comporte un dispositif d'affichage graphique ou lumineux, tel qu'une lampe témoin ou un écran d'affichage.

7. Module auxiliaire de protection électrique selon l'une quelconque des revendications précédentes, dans lequel le système de mesure du courant (30) comporte un circuit de traitement (34) connecté en sortie du capteur de courant (32) et à une entrée (20c) du processeur, ledit circuit de traitement (34) étant configuré pour échantillonner le courant mesuré et générer une image du courant électrique mesuré circulant au travers de l'appareil de protection.

8. Module auxiliaire de protection électrique selon la revendication 7, dans lequel le processeur (20) est configuré pour détecter un défaut différentiel et pour transmettre un ordre de déclenchement au mécanisme de commutation.

9. Module auxiliaire de protection électrique selon l'une quelconque des revendications 1 à 6, dans lequel le système de mesure du courant (30) comporte un circuit de traitement (34) connecté en sortie du capteur de courant (32), le circuit de traitement (34) étant configuré pour amplifier le courant mesuré et/ou traiter de façon analogique la fonction de protection afin de détecter un défaut différentiel.

10. Module auxiliaire de protection électrique selon la revendication 9, dans lequel le circuit de traitement (34) est configuré pour détecter un défaut différentiel et pour transmettre un ordre de déclenchement au mécanisme de commutation.

11. Appareil de protection électrique (2) comportant un module auxiliaire de protection électrique (6) et un mécanisme de commutation (4) couplé au module de protection, ledit module auxiliaire de protection électrique étant conforme à l'une quelconque des revendications précédentes.

12. Procédé de fonctionnement d'un module auxiliaire de protection électrique (6) dans un appareil de protection électrique (2) comportant un mécanisme de commutation (4) couplé à des contacts électriques, le mécanisme de commutation étant configuré pour être commuté entre une position fermée empêchant le passage du courant au travers de l'appareil et une position ouverte permettant le passage du courant,
le procédé comportant des étapes mises en œuvre par un processeur (20) du module de protection électrique et comportant :
- identifier, à partir au moins d'un système de mesure de position (30) du module de protection électrique, un déclenchement de l'appareil de protection,
- identifier a partir au moins d'un système de mesure du courant (40) une cause d'un déclenchement de l'appareil de protection,
le système de mesure de position étant couplé au processeur et étant configuré pour détecter la position du mécanisme de commutation, le système de mesure de position (40) étant connecté à une source de tension pour fournir une tension de référence sur une entrée du processeur lorsque le mécanisme de commutation est dans la position fermée, le système de mesure de position étant configuré pour modifier ladite alimentation lorsque le mécanisme de commutation est dans la position ouverte, le système de mesure de courant étant couplé au processeur afin de détecter un courant électrique circulant au travers de l'appareil électrique, ;
- décompter (102, 104, 108) la durée écoulée depuis la dernière occurrence d'un déclenchement de l'appareil de protection causé par un défaut différentiel ;
- émettre un signal d'alarme (132) lorsque la durée décomptée dépasse un seuil prédéfini.
